# EUROPEAN PATENT APPLICATION

(11) **EP 4 567 815 A2**
(43) Date of publication of application: **11.06.2025**
(21) Application number: 24210395.0
(22) Date of filing: 01.11.2024
(51) Int. Cl.: G11C 29/56

(54) **METHOD AND APPARATUS TO REDUCE SIZE OF MEMORY TO STORE TEST CONTENT IN A CHANNEL CARD IN AUTOMATIC TEST EQUIPMENT TO TEST AN INTEGRATED CIRCUIT**

(30) Priority: 04.12.2023 US 202318528281
(71) Applicant: INTEL Corporation, Santa Clara, CA 95054 (US)
(72) Inventor: ROLLINS, Shelby G., Hillsboro, OR 97124 (US); PATHY, Sundar V., Chandler, AZ 85249 (US)
(74) Representative: HGF

(57) **Abstract**

A portion of test content to test a Device Under Test (DUT) in Automatic Test Equipment (ATE) is loaded by a controller in the ATE in a memory partition in a channel card in the ATE prior to start of the test of the DUT. A next portion of the test content is dynamically loaded by the controller in another partition of the memory while the portion of test content is being used to test the DUT. The size of the memory in the channel card is reduced because all test content for the test of the DUT is not stored in the memory prior to start of the test of the DUT.

## Description

### BACKGROUND INFORMATION

Semiconductor Automatic Test Equipment (ATE) performs tests on a device that is typically referred to as a device under test (DUT) using automation to perform tests and evaluate the test results. The semiconductor ATE can test and diagnose faults on semiconductor devices including integrated circuits. The semiconductor ATE can test packaged semiconductor devices or wafers.

The semiconductor ATE typically interfaces with an automated placement tool (handler) that physically places the DUT on an interface test adapter (ITA) or "fixture" so that it can be tested.

The semiconductor ATE includes a main controller (for example, a computer) and a channel card that interfaces with the DUT. The DUT is physically connected to the semiconductor ATE through the interface test adapter.

### BRIEF DESCRIPTION OF THE DRAWINGS

Various examples in accordance with the present disclosure will be described with reference to the drawings, in which:
FIG. 1 is a block diagram of an example of a semiconductor Automatic Test Equipment system to test a Device Under Test (DUT);
FIG. 2 is a block diagram illustrating use of the memory in the channel card to store test contents used to test the DUT;
FIG. 3 is a flowgraph illustrating a method for communicating between the a channel card and TOS during test of the DUT; and
FIG. 4 illustrates a block diagram of an example of a DUT that may have one or more cores, an integrated memory controller and a JTAG port.

### DETAILED DESCRIPTION

The main controller in the semiconductor ATE includes a storage device, for example, a hard disk drive or a solid state drive to store test content used by the channel card to test the DUT. Prior to testing the DUT, the test content is read from the storage device and written to a volatile memory (for example, a Dynamic Random Access Memory (DRAM)) in the channel card.

Test content required to test integrated circuits has increased to match the increase in transistor density in the integrated circuits. In a typical test platform test content is stored in channel cards and delivered many times to different DUTs via execution engines on the channel card. As the execution engines in the channel card testing the DUTs may make local non-predictable branch decisions at run time, the channel card cannot be directly controlled by the main controller during the execution of the test content. As a result all test content must be loaded in volatile memory in the channel card prior to the start of the test of the integrated circuit. Ten percent of the typical cost of the semiconductor ATE is volatile memory in channel cards that is used to store all of the test content. For example, channel cards in a semiconductor ATE typically include 64GB, or more, of volatile memory (for example, DRAM) per execution engine to store all test content. A channel card with four execution engines includes 256GB of DRAM.

Instead of loading all test content in volatile memory in the channel card prior to start of the test of the integrated circuit, a portion of the test content is loaded prior to the start of the test. During execution of the test of the integrated circuit, the channel card sends updates to the main controller so that the main controller can dynamically load new test content in the volatile memory in the channel card. The test content that is stored in the volatile memory in channel cards is thus reduced compared to the full load of the test content. Delivering new test data in response to updates from the channel card provides about the same level of performance while also enabling a reduction in the size of the DRAM per execution engine (for example, from 64GB to 1GB) in the channel card. Since the channel card is still executing run time flow decisions and notifying the main controller through updates no functionality or other requirements of the test of the integrated circuit are impacted.

Various embodiments and aspects of the inventions will be described with reference to details discussed below, and the accompanying drawings will illustrate the various embodiments. The following description and drawings are illustrative of the invention and are not to be construed as limiting the invention. Numerous specific details are described to provide a thorough understanding of various embodiments of the present invention. However, in certain instances, well-known or conventional details are not described in order to provide a concise discussion of embodiments of the present inventions.

Reference in the specification to "one embodiment" or "an embodiment" means that a particular feature, structure, or characteristic described in conjunction with the embodiment can be included in at least one embodiment of the invention. The appearances of the phrase "in one embodiment" in various places in the specification do not necessarily all refer to the same embodiment.

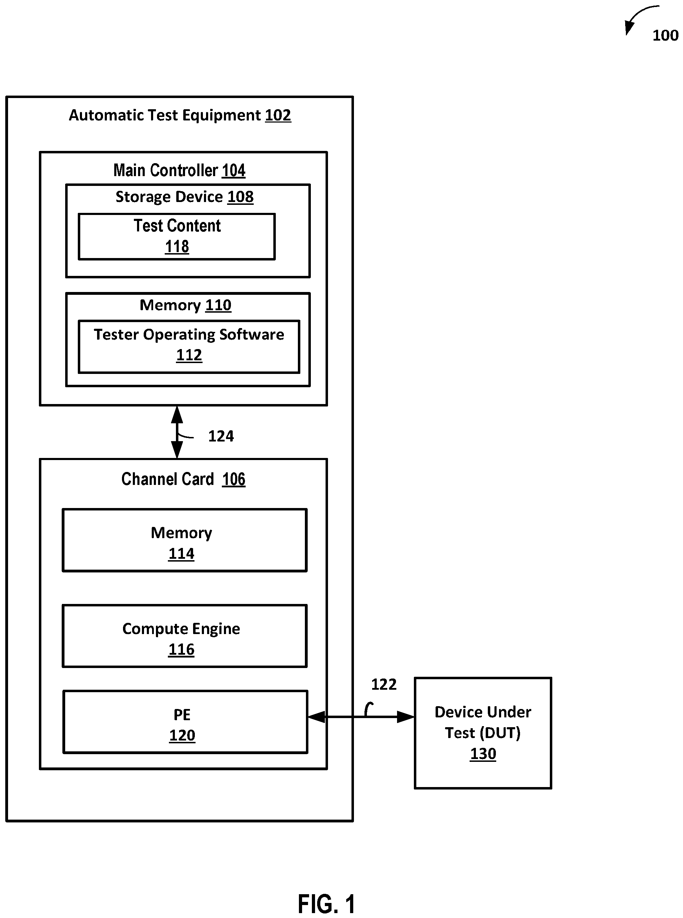

FIG. 1 is a block diagram of an example of a semiconductor Automatic Test Equipment system 100 to test a Device Under Test (DUT) 130. In the example shown the DUT 130 is an integrated circuit. Examples of integrated circuits include a processor, a System-on-Chip (SoC), a Central Processing Unit (CPU), a Graphics Processing Unit (GPU), and a Field Programable Gate Array (FPGA).

The semiconductor Automatic Test Equipment system 100 includes a main controller 104 and a channel card 106. The main controller 104 includes a storage device 108 to store test content 118 and memory 110 to store tester operating software. The main controller 104 and the channel card 106 communicate over a backplane 124.

The channel card 106 interfaces with the DUT 130. The channel card 106 includes a memory 114 to store test content to test the DUT 130. The channel card 106 delivers the test content stored in the memory 114 many times to the DUT 130. The channel card 106 includes a compute engine 116 and pin electronics (PE) 120.

Examples of a compute engine 116 include a processor, a System-on-Chip (SoC), a Central Processing Unit (CPU), a Graphics Processing Unit (GPU), a Field Programable Gate Array (FPGA) and Application Specific Integrated Circuit (ASIC). The memory 114 is a volatile memory. Volatile memory is memory whose state (and therefore the data stored in it) is indeterminate if power is interrupted to the device. Dynamic volatile memory requires refreshing the data stored in the device to maintain state. One example of dynamic volatile memory includes DRAM (Dynamic Random Access Memory), or some variant such as Synchronous DRAM (SDRAM).

The pin electronics (PE) 120 is an integrated circuit that communicates with the DUT 130 over a standard Input/Output (I/O) bus 122, for example, Joint Test Action Group (JTAG), Peripheral Component Interconnect (PCI)-Express (PCIe), I2C, Serial Peripheral Interface (SPI).

The tester operating software 1 12 accesses test content 118 from the storage device 108 and sends a portion of the test content 118 over the backplane 124 to the channel card 106 prior to start of the test of the DUT 130. The compute engine 116 stores the received test content in memory 114 and uses the received portion of the test content 118 to start testing the DUT 130.

The compute engine 116 sends updates to the main controller 104 over the backplane 124 during the testing of the DUT 130. In response to the received updates, the tester operating software 112 accesses a new portion of the test content from the test content 118 stored in the storage device and sends the new portion of the test content over the backplane 124 to be stored in the memory 114 in the channel card 106 and used by the PE 120 to test the DUT 130.

In an embodiment, there are four compute engines 116 in the channel card 106 and 14 channel cards 106 in the Automatic Test Equipment 102.

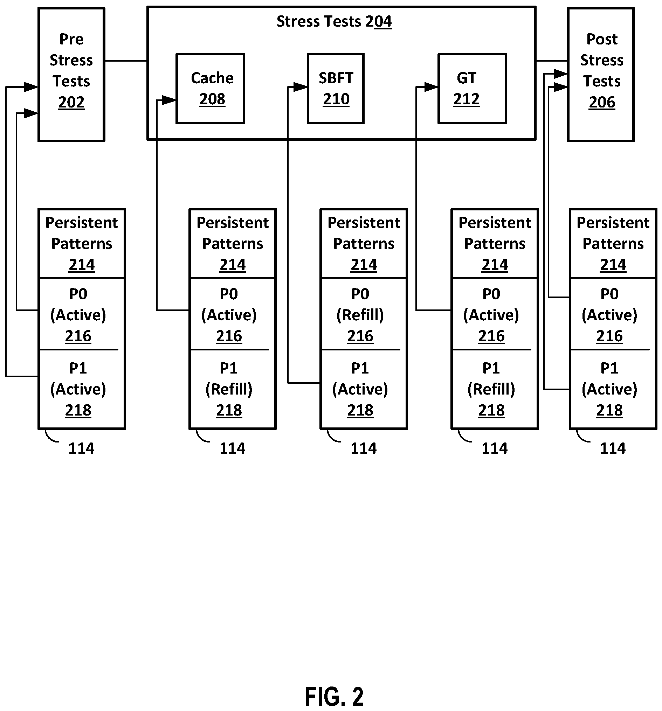

FIG. 2 is a block diagram illustrating use of the memory 114 in the channel card 106 to store test contents to test the DUT 130. The memory 114 in the channel card 106 is organized in pages/partitions and can be loaded with new test contents stored in the storage device 108 in the main controller 104 prior to performing a test using the new test contents. The loading of new test contents in the memory 114 in the channel card 106 during the test of the DUT 130 can be referred to as Bottomless Vector Memory (BVM).

The memory 114 stores test content that can include patterns (main, subroutine), a pattern list (plist) and captures. Patterns are test content that is used to stimulate the DUT 130. The patterns in conjunction with instructions are used by the compute engine 116 to run a test program. A main pattern is a main block of test vectors to be sent to the DUT 130. A subroutine pattern is another block of test vectors to the sent to the DUT 130 that can be re-executed multiple times via the main pattern. The pattern list (plist) is a list of main patterns. Capture result data created by the DUT 130 during the test of the DUT 130 is compared with expected results stored in the test patterns for the DUT 130 and stored in the channel card memory 114.

The test content can be generated from simulation traces or functional specifications for the DUT 130 or can be manually generated. For example, the functional specifications for an integrated circuit can include a initialization sequence performed during reset of the integrated circuit that includes providing power to the integrated circuit and starting clocks in the integrated circuit.

In an embodiment, the memory 114 is limited to 4 Giga Vectors (GV) (64 Giga Bytes (GB)), with each vector having 128 bits. The pattern list is a list of test contents to be merged into a single execution flow. In an embodiment, the pattern list is an Extensible Markup Language (XML) file. XML is a file format for storing, transmitting, and reconstructing arbitrary data. The tester operating software 112 uses a single XML file that includes the total set of test content for program load.

Prior to starting the test of the DUT 130, a set of patterns (for example, test content and/or an initialization sequence) is loaded by the tester operating software 112 in partition 0 (P0) 216 and partition 1 (P1) 218 in the memory 114. The tester operating software 112 loads a set of patterns based on the number of patterns that can be stored in P0 216 and P1 218 in the memory 114. The test content for a current stress test is stored in a first partition in the memory 114 while the current stress test is being performed in the DUT 130 and the test content for a subsequent stress test is written to a second partition in the memory 114.

During the test of the DUT, patterns that are not stored in P0 216 and P1 218 in the memory 114 on the channel card 106 prior to the start of the test of the DUT 130 are loaded on-demand. The Tester Operating Software 112 overwrites some of the patterns stored in the memory 114 with other patterns in the memory 114. A burst is a flow set of patterns that includes setup patterns, test patterns and teardown patterns to bring the DUT into a testable state, perform tests in the DUT, and shut down the DUT. The setup patterns can include device unlocking, trims, or other sequences. The patterns for the burst are loaded in the memory 114 by the tester operating software 112 prior to the start of the burst. The patterns are loaded in the order of the plist. The time to test the DUT 130 may increase due to time to load patterns in the memory 114 during the test of the DUT 130. For example, it may take up to 40 seconds to load 2 GV in the memory 114 during the time to load the patterns.

A persistent patterns partition 214 of the memory 114 is reserved to store patterns that cannot be swapped out during the test of the DUT 130. A list of persistent patterns to be stored in the persistent patterns partition 214 of the memory 114 can be specified in the plist. The Tester Operating Software 112 provides the size of the persistent patterns partition 214 of memory 114 and also provides Application Programming Interface (API)s to read/add/remove persistent patterns from the persistent patterns partition 214 of memory 114. Parameters that are reserved by Tester Operating Software 112 cannot be removed from the persistent patterns partition 214 (also referred to as a portion) of the memory 114. Patterns reserved by tester operating software 112 include subroutine patterns and modified patterns. As subroutine patterns are called multiple times they are added to the persistent patterns partition 214 of the memory 114. A pattern can be loaded in the persistent patterns partition 214 of the memory 114. The pattern can be modified before or after it is loaded in the persistent patterns partition 214 of the memory 114.

In the example shown in FIG. 2, pre-stress tests 202 are performed in the DUT 130 prior to performing the stress tests 204 in the DUT 130. The stress tests 204 include a cache test 208, a Structural Based Functional Test (SBFT) 210 and a Graphics Test (GT) 212. The structural based function test 210 performs complex operations that cannot be real time stimulated directly by a scan network. For example, a complex operation can load cache with a program to be executed by a CPU. The signature of the CPU state at the completion of the execution of the program or the data written back into the cache at the completion of the program can be checked to determine if program was executed correctly. Capture data and result status can also be streamed to the main controller periodically from the channel card.

The Graphics Test 212 includes test content to stimulate graphics shader chains to check that the data pipeline is functional. The cache test 208 can perform a march test by applying patterns that "march" up and down the memory address while writing values to and reading values from known memory locations.

Prior to performing the pre-stress tests 202, the test content for the pre-stress tests 202 is loaded into P0 212 and P1 218 of the memory 114. After the pre-stress tests 202 have been performed, the stress tests 204 are performed. Prior to the start of the stress tests 204, the tester operating software 112 writes the test contents for the cache test 208 into P0 212 of the memory 114.

After the test contents for the cache test 208 have been written into P0 212 of the memory 114, the test contents for the cache test 208 is loaded into the DUT 130. While the cache test 208 is performed in the DUT 130, test contents for the structural based functional test 210 are written the tester operating software 112 into P1 212 of the memory 114.

After the cache test 208 has been performed in the DUT 130, the test contents for the structural based functional test 210 in P1 212 of the memory 114 are loaded in the DUT 130. While the structural based functional test 210 is performed in the DUT 130, test contents for the Graphics Test 212 are written by the tester operating software 112 into P0 212 of the memory 114.

After the Graphics Test 212 has been performed in the DUT 130, the test contents for the post stress tests 206 are written the tester operating software 112 to P0 216 and P1 218 of the memory 114. Post stress tests 206 perform the pre-stress tests 202 in the DUT 130 after the stress tests 204 have been performed to check if the DUT 130 was damaged during the stress tests 204.

In the embodiment shown in FIG. 2, there are two partitions (partition 0 (P0) 216 and partition 1 (P1) 218) in the memory 114. In other embodiments, there can be more than two partitions, for example, three or more than three partitions.

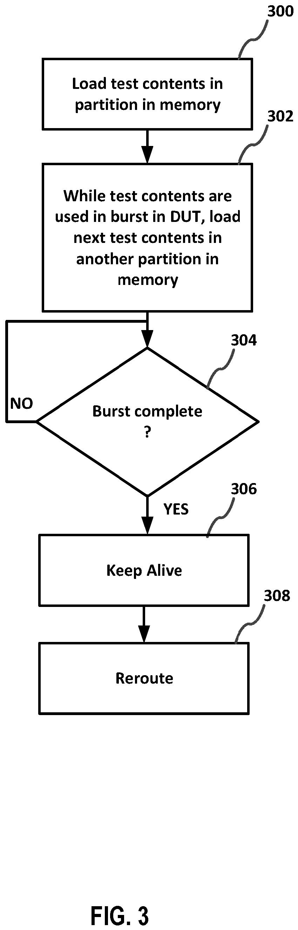

FIG. 3 is a flowgraph illustrating operation of the interface between the channel card 106 and Tester Operating software 112 during test of the DUT 130.

At block 300, the tester operating software 112 loads first test contents for a first test in a first partition of the memory 114 in the channel card 106. The compute engine 116 in the channel card loads the first test contents stored in memory 114 in the DUT 130 via the PE 120. The first test contents can be included in a burst. A burst is a continuous transmission of data to/from the DUT 130. The burst can take less than 1 second or more than 100 seconds.

At block 302, while the first test contents are used in the burst in the DUT 130, the tester operating software 112 loads next test contents for a second test in a second partition of the memory 114 in the channel card 106.

At block 304, if the tester operating software 112 has received a trigger notification that the burst has been completed, processing continues with block 306.

At block 306, the compute engine 116 executes a keep-alive pattern in the PLIST. The keep-alive pattern is a filler pattern used to keep the DUT 130 alive so that the DUT 130 setup sequences do not need to be re-executed. The keep-alive pattern keep the clocks running in the DUT 130 and maintain the state of the DUT 130. In an embodiment, the keep-alive pattern is an instruction repeat (IRPT) that executes a data vector multiple times with minimal use of vector memory. The data vector is executed by driving and/or strobing signals over the standard Input/Output (I/O) bus 122 adapted to the DUT (for example, cables or fiber or printed circuit board (PCB) connectors). The compute engine 116 executes a set of instructions (keep-alive jump logic) to stop sending the keep-alive pattern.

At block 308, dynamic reroute is performed. The tester operating software 112 writes the address of the next main block of test vectors stored in memory 114 to be sent to the DUT 130 in a static keep alive location in memory 114 to select the second partition in the memory 114 that stores the next test contents (block of test vectors) to be sent to the DUT 130.

An embodiment has been described for automatic test equipment 102 that includes a separate main controller 104 and a channel card 106. In another embodiment, the circuitry (memory 114, compute engine 116 and PE 120) in the channel card 106 can be included in the main controller 104 in the automatic test equipment 102.

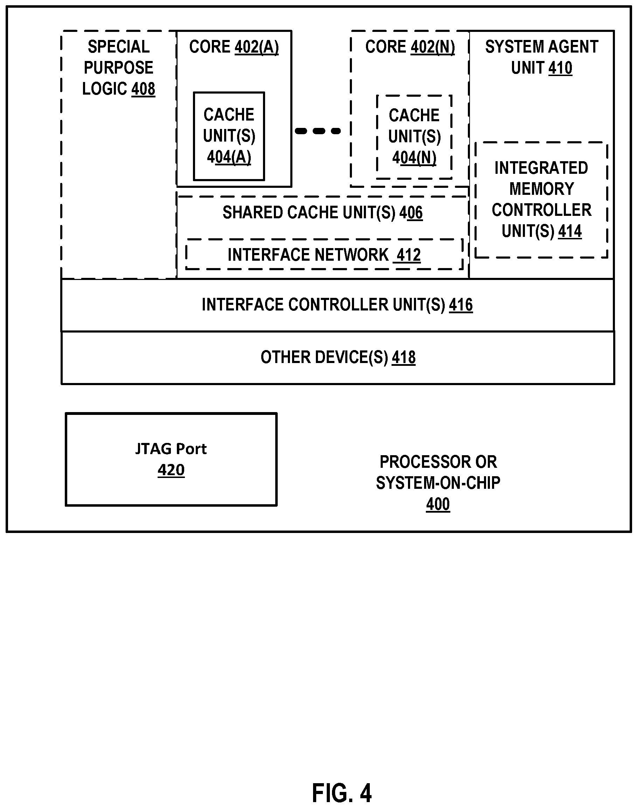

FIG. 4 illustrates a block diagram of an example DUT that may have one or more cores, an integrated memory controller and a JTAG (Joint Test Action Group) port. The DUT can be a System on Chip (SoC) or a processor 400 that includes different components (hardware elements), also called "blocks" or subsystems.

The solid lined boxes illustrate a processor 400 with a single core 402(A), system agent unit circuitry 410, and a set of one or more interface controller unit(s) circuitry 416, while the optional addition of the dashed lined boxes illustrates an alternative processor 400 with multiple cores 402(A)-(N), a set of one or more integrated memory controller unit(s) circuitry 414 in the system agent unit circuitry 410, and special purpose logic 408, as well as a set of one or more interface controller unit(s) circuitry 416.

Thus, different implementations of the processor 400 may include: 1) a CPU with the special purpose logic 408 being integrated graphics and/or scientific (throughput) logic (which may include one or more cores, not shown), and the cores 402(A)-(N) being one or more general purpose cores (e.g., general purpose in-order cores, general purpose out-of-order cores, or a combination of the two); 2) a coprocessor with the cores 402(A)-(N) being a large number of special purpose cores intended primarily for graphics and/or scientific (throughput); and 3) a coprocessor with the cores 402(A)-(N) being a large number of general purpose in-order cores. Thus, the processor 400 may be a general-purpose processor, coprocessor or specialpurpose processor, such as, for example, a network or communication processor, compression engine, graphics processor, GPGPU (general purpose graphics processing unit), a high throughput many integrated core (MIC) coprocessor (including 30 or more cores), embedded processor, or the like. The processor may be implemented on one or more chips. The processor 400 may be a part of and/or may be implemented on one or more substrates using any of a number of process technologies, such as, for example, complementary metal oxide semiconductor (CMOS), bipolar CMOS (BiCMOS), P-type metal oxide semiconductor (PMOS), or N-type metal oxide semiconductor (NMOS).

A memory hierarchy includes one or more levels of cache unit(s) circuitry 404(A)-(N) within the cores 402(A)-(N), a set of one or more shared cache unit(s) circuitry 406, and external memory (not shown) coupled to the set of integrated memory controller unit(s) circuitry 414. The set of one or more shared cache unit(s) circuitry 406 may include one or more mid-level caches, such as level 2 (L2), level 3 (L3), level 4 (L4), or other levels of cache, such as a last level cache (LLC), and/or combinations thereof. While in some examples interface network circuitry 412 (e.g., a ring interconnect) interfaces the special purpose logic 408 (e.g., integrated graphics logic), the set of shared cache unit(s) circuitry 406, and the system agent unit circuitry 410, alternative examples use any number of well-known techniques for interfacing such units. In some examples, coherency is maintained between one or more of the shared cache unit(s) circuitry 406 and cores 402(A)-(N). In some examples, interface controller unit(s) circuitry 416 couple the cores 402 to one or more other devices 418 such as one or more I/O devices, storage, one or more communication devices (e.g., wireless networking, wired networking, etc.), etc.

In some examples, one or more of the cores 402(A)-(N) are capable of multi-threading. The system agent unit circuitry 410 includes those components coordinating and operating cores 402(A)-(N). The system agent unit circuitry 410 may include, for example, power control unit (PCU) circuitry and/or display unit circuitry (not shown). The PCU may be or may include logic and components needed for regulating the power state of the cores 402(A)-(N) and/or the special purpose logic 408 (e.g., integrated graphics logic). The display unit circuitry is for driving one or more externally connected displays.

The cores 402(A)-(N) may be homogenous in terms of instruction set architecture (ISA). Alternatively, the cores 402(A)-(N) may be heterogeneous in terms of ISA; that is, a subset of the cores 402(A)-(N) may be capable of executing an ISA, while other cores may be capable of executing only a subset of that ISA or another ISA.

The JTAG port 420 is an industry standard interface that implements a serial communications interface to provide access to a set of test registers in the integrated circuit. Internal monitoring capabilities (for example, temperature, voltage and current) in the integrated circuit are accessible via the JTAG port.

The Institute of Electrical and Electronics Engineers (IEEE) 1149.1 Standard JTAG port uses four pins and one optional pin on the integrated circuit. The four pins are TDI (Test Data In), TDO (Test Data Out), TCK (Test Clock) and TMS (Test Mode Select). The optional pin is TRST (Test Reset). The clock input is at the TCK pin. Data is written and read serially via the JTAG port with one bit of data transferred in from TDI, and out to TDO serially per TCK rising clock edge.

Modules (for example, Voltage droop monitors and Temperature sensors) in the processor 400 expose test access ports (TAPs). A host communicates with the TAPs via the JTAG port 420 by manipulating Test Mode Select (TMS) and TDI in conjunction with TCK, and reading results through TDO. Each TAP has one instruction register (IR) and multiple data registers (DR). The number of bits in the data registers varies between TAPs. The data registers are combined through TDI and TDO to form a large shift register. All information (instructions, test data, and test results) is communicated in a serial format.

While various embodiments described herein use the term System-on-a-Chip or System-on-Chip ("SoC") to describe a device or system having a processor and associated circuitry (e.g., Input/Output ("I/O") circuitry, power delivery circuitry, memory circuitry, etc.) integrated monolithically into a single Integrated Circuit ("IC") die, or chip, the present disclosure is not limited in that respect. For example, in various embodiments of the present disclosure, a device or system can have one or more processors (e.g., one or more processor cores) and associated circuitry (e.g., Input/Output ("I/O") circuitry, power delivery circuitry, etc.) arranged in a disaggregated collection of discrete dies, tiles and/or chiplets (e.g., one or more discrete processor core die arranged adjacent to one or more other die such as memory die, I/O die, etc.). In such disaggregated devices and systems the various dies, tiles and/or chiplets can be physically and electrically coupled together by a package structure including, for example, various packaging substrates, interposers, active interposers, photonic interposers, interconnect bridges and the like. The disaggregated collection of discrete dies, tiles, and/or chiplets can also be part of a System-on-Package ("SoP").

Program code may be applied to input information to perform the functions described herein and generate output information. The output information may be applied to one or more output devices, in known fashion. For purposes of this application, a processing system includes any system that has a processor, such as, for example, a digital signal processor (DSP), a microcontroller, an application specific integrated circuit (ASIC), a field programmable gate array (FPGA), a microprocessor, or any combination thereof.

The program code may be implemented in a high-level procedural or object-oriented programming language to communicate with a processing system. The program code may also be implemented in assembly or machine language, if desired. In fact, the mechanisms described herein are not limited in scope to any particular programming language. In any case, the language may be a compiled or interpreted language.

Examples of the mechanisms disclosed herein may be implemented in hardware, software, firmware, or a combination of such implementation approaches. Examples may be implemented as computer programs or program code executing on programmable systems comprising at least one processor, a storage system (including volatile and non-volatile memory and/or storage elements), at least one input device, and at least one output device.

One or more aspects of at least one example may be implemented by representative instructions stored on a machine-readable medium which represents various logic within the processor, which when read by a machine causes the machine to fabricate logic to perform the techniques described herein. Such representations, known as "intellectual property (IP) cores" may be stored on a tangible, machine readable medium and supplied to various customers or manufacturing facilities to load into the fabrication machines that make the logic or processor.

Such machine-readable storage media may include, without limitation, non-transitory, tangible arrangements of articles manufactured or formed by a machine or device, including storage media such as hard disks, any other type of disk including floppy disks, optical disks, compact disk read-only memories (CD-ROMs), compact disk rewritables (CD-RWs), and magneto-optical disks, semiconductor devices such as read-only memories (ROMs), random access memories (RAMs) such as dynamic random access memories (DRAMs), static random access memories (SRAMs), erasable programmable read-only memories (EPROMs), flash memories, electrically erasable programmable read-only memories (EEPROMs), phase change memory (PCM), magnetic or optical cards, or any other type of media suitable for storing electronic instructions.

Accordingly, examples also include non-transitory, tangible machine-readable media containing instructions or containing design data, such as Hardware Description Language (HDL), which defines structures, circuits, apparatuses, processors and/or system features described herein. Such examples may also be referred to as program products.

References to "one example," "an example," etc., indicate that the example described may include a particular feature, structure, or characteristic, but every example may not necessarily include the particular feature, structure, or characteristic. Moreover, such phrases are not necessarily referring to the same example. Further, when a particular feature, structure, or characteristic is described in connection with an example, it is submitted that it is within the knowledge of one skilled in the art to affect such feature, structure, or characteristic in connection with other examples whether or not explicitly described.

Moreover, in the various examples described above, unless specifically noted otherwise, disjunctive language such as the phrase "at least one of A, B, or C" or "A, B, and/or C" is intended to be understood to mean either A, B, or C, or any combination thereof (i.e. A and B, A and C, B and C, and A, B and C).

The specification and drawings are, accordingly, to be regarded in an illustrative rather than a restrictive sense. It will, however, be evident that various modifications and changes may be made thereunto without departing from the broader spirit and scope of the disclosure as set forth in the claims.

### EXAMPLES

Illustrative examples of the technologies disclosed herein are provided below. An embodiment of the technologies may include any one or more, and any combination of, the examples described below.

Example 1 is an Automatic Test Equipment (ATE) system comprising a controller and a channel card. The controller comprising a storage device to store a test content to test a device under test. The channel card communicatively coupled to the controller. The channel card comprising a memory to store a first portion of the test content received from the controller in a first partition of the memory. The channel card to load the first portion of the test content in the device under test. The memory to store a second portion of the test content received from the controller in a second partition of the memory while the first portion of the test content is used to test the device under test.

Example 2 includes the system of Example 1, the device under test is communicatively coupled to the channel card.

Example 3 includes the system of Example 1, optionally the channel card includes a compute engine. The compute engine to load the first portion of the test content in the device under test

Example 4 includes the system of Example 3,optionally the compute engine is a Field Programmable Gate Array (FPGA), a processor, a System-on-Chip (SoC), a Graphics Processing Unit (GPU) or an Application Specific Integrated Circuit (ASIC).

Example 5 includes the system of Example 1, optionally the memory includes a persistent patterns partition to store patterns that cannot be swapped out of the memory during the test of the device under test.

Example 6 includes the system of Example 1, optionally the memory includes more than three partitions to store the test content.

Example 7 includes the system of Example 1, optionally the device under test is an integrated circuit.

Example 8 is an apparatus comprising a memory and a compute engine. The compute engine communicatively coupled to the memory and to a controller. The controller comprising a storage device to store test content to test a device under test. The memory to store a first portion of the test content received from the controller in a first partition of the memory. The compute engine to load the first portion of the test content in the device under test. The memory to store a second portion of the test content received from the controller in a second partition of the memory while the first portion of the test content is used to test the device under test.

Example 9 includes the apparatus of Example 8, optionally the device under test is communicatively coupled to the compute engine.

Example 10 includes the apparatus of Example 9, optionally the compute engine is a Field Programmable Gate Array (FPGA)), a processor, a System-on-Chip (SoC), a Graphics Processing Unit (GPU) or an Application Specific Integrated Circuit (ASIC).

Example 11 includes the apparatus of Example 8, optionally wherein the memory includes a persistent patterns partition to store patterns that cannot be swapped out of the memory during the test of the device under test.

Example 12 includes the apparatus of Example 8, optionally the memory includes more than three partitions to store the test content.

Example 13 includes the apparatus of Example 8, optionally the device under test is an integrated circuit.

Example 14 is a method comprising storing test content to test a device under test in a storage device in a controller. The method also includes storing, a first portion of the test content received from the controller in a first partition of a memory in a channel card communicatively coupled to the controller. The method also includes loading, by the channel card, the first portion of the test content in the device under test. The method also includes storing, a second portion of the test content received from the controller in a second partition of the memory while the first portion of the test content is used to test the device under test.

Example 15 includes the method of Example 14, optionally the device under test is communicatively coupled to the compute engine.

Example 16 includes the method of Example 14, wherein the channel card includes a compute engine, the compute engine to load the first portion of the test content in the device under test.

Example 17 includes the method of Example 16, optionally the compute engine is a Field Programmable Gate Array (FPGA)), a processor, a System-on-Chip (SoC), a Graphics Processing Unit (GPU) or an Application Specific Integrated Circuit (ASIC).

Example 18 includes the method of Example 14, optionally the memory includes a persistent patterns partition to store patterns that cannot be swapped out of the memory during the test of the device under test.

Example 19 includes the method of Example 14, optionally the memory includes more than three partitions to store the test content.

Example 20 includes the method of Example 14, optionally the device under test is an integrated circuit.

Example 21 is at least one machine readable medium that includes a plurality of instructions that in response to being executed by a system can cause the system to carry out a method according to any one of examples 14 to 20.

Example 22 is an apparatus that includes means for performing the methods of any one of examples 14 to 20.

## Claims

1. An Automatic Test Equipment (ATE) system comprising:
a controller, the controller comprising a storage device to store a test content to test a device under test; and
a channel card communicatively coupled to the controller, the channel card comprising a memory to store a first portion of the test content received from the controller in a first partition of the memory, the channel card to load the first portion of the test content in the device under test and the memory to store a second portion of the test content received from the controller in a second partition of the memory while the first portion of the test content is used to test the device under test.

2. The system of claim 1, wherein the channel card includes a compute engine, the compute engine to load the first portion of the test content in the device under test.

3. The system of claim 1, wherein the memory includes a persistent patterns partition to store patterns that cannot be swapped out of the memory during the test of the device under test.

4. The system of claim 1, wherein the memory includes more than three partitions to store the test content.

5. The system of claim 1, wherein the device under test is an integrated circuit.

6. An apparatus comprising:
a memory; and
a compute engine, the compute engine communicatively coupled to the memory and to a controller, the controller comprising a storage device to store test content to test a device under test, the memory to store a first portion of the test content received from the controller in a first partition of the memory, the compute engine to load the first portion of the test content in the device under test and the memory to store a second portion of the test content received from the controller in a second partition of the memory while the first portion of the test content is used to test the device under test.

7. The apparatus of claim 6, wherein the memory includes a persistent patterns partition to store patterns that cannot be swapped out of the memory during the test of the device under test.

8. The apparatus of claim 6, wherein the memory includes more than three partitions to store the test content.

9. A method comprising:
storing test content to test a device under test in a storage device in a controller; and
storing, a first portion of the test content received from the controller in a first partition of a memory in a channel card communicatively coupled to the controller;
loading, by the channel card, the first portion of the test content in the device under test; and
storing, a second portion of the test content received from the controller in a second partition of the memory while the first portion of the test content is used to test the device under test.

10. The method of claim 9, wherein the device under test is communicatively coupled to the channel card.

11. The method of claim 9, wherein the channel card includes a compute engine, the compute engine to load the first portion of the test content in the device under test.

12. The method of claim 9, wherein the memory includes a persistent patterns partition to store patterns that cannot be swapped out of the memory during the test of the device under test.

13. A computer-readable medium on which instructions are stored in a non-transitory form, that when executed by a computer, cause a system to perform the method of:
storing test content to test a device under test in a storage device in a controller; and
storing, a first portion of the test content received from the controller in a first partition of a memory in a channel card communicatively coupled to the controller;
loading, by the channel card, the first portion of the test content in the device under test; and
storing, a second portion of the test content received from the controller in a second partition of the memory while the first portion of the test content is used to test the device under test.

14. The computer-readable medium of claim 13 wherein the channel card includes a compute engine, the compute engine to load the first portion of the test content in the device under test.

15. The computer-readable medium of claim 13 wherein the memory includes a persistent patterns partition to store patterns that cannot be swapped out of the memory during the test of the device under test.
